# EUROPÄISCHE PATENTSCHRIFT

(11) **EP 4 291 906 B1**
(45) Veröffentlichungstag und Bekanntmachung des Hinweises auf die Patenterteilung: **25.12.2024**
(21) Anmeldenummer: 22701622.7
(22) Anmeldetag: 25.01.2022
(51) Int. Cl.: G01R 1/20, G01R 15/14, G01R 19/00

(54) **STROMMESSWIDERSTAND**
CURRENT-SENSING RESISTOR
RÉSISTANCE DE DÉTECTION DE COURANT

(30) Priorität: 11.02.2021 DE 102021103241
(43) Veröffentlichungstag der Anmeldung: 20.12.2023
(73) Patentinhaber: Isabellenhütte Heusler GmbH & Co. KG, 35683 Dillenburg (DE)
(72) Erfinder: BAUM, Andreas, 35080 Bad Endbach (DE); ESCHER, Marcus, 35708 Haiger (DE); FEY, Arno, 35683 Dillenburg (DE); LIPPERT, Wayne, 35582 Wetzlar (DE); OSTASCH, Rainer, 82110 Germering (DE)
(74) Vertreter: v. Bezold & Partner Patentanwälte - PartG mbB
(86) Internationale Anmeldenummer: PCT/EP2022/051560
(87) Internationale Veröffentlichungsnummer: WO 2022/171427

(56) Entgegenhaltungen:
- DE-A1- 102014 011 593
- DE-U1- 202013 011 690
- US-A1- 2017 307 660
- US-A1- 2020 292 588

## Beschreibung

Die Erfindung betrifft einen Widerstand, insbesondere einen niederohmigen Strommesswiderstand.

Aus dem Stand der Technik (z.B. EP 0 605 800 A1) ist es bekannt, elektrische Ströme gemäß der sogenannten Vierleitertechnik mittels eines niederohmigen Strommesswiderstands zu messen, der auch als "Shunt" bezeichnet wird. Hierbei wird der zu messende elektrische Strom durch den Strommesswiderstand geleitet, wobei der Spannungsabfall über einem Widerstandselement des Strommesswiderstands gemessen wird. Der gemessene Spannungsabfall ist dann entsprechend dem Ohmschen Gesetz ein Maß für den elektrischen Strom, der durch den Strommesswiderstand fließt.

Aus WO 2014/161624 A1 ist ein solcher Strommesswiderstand bekannt, der mehrere Paare von Spannungsmesskontakten aufweist, die bezüglich der Stromflussrichtung in dem Strommesswiderstand nebeneinander angeordnet sind. Die einzelnen Paare von Spannungsmesskontakten liefern hierbei jeweils einen Spannungsmesswert an unterschiedlichen Stellen des Widerstandselements. Die einzelnen Spannungsmesswerte können dann gemittelt werden, um die Genauigkeit der Messung zu erhöhen. Hierbei erfolgt die Spannungsmessung jeweils parallel zur Hauptstromflussrichtung in dem Strommesswiderstand, da die Paare von Spannungsmesskontakten nicht über Kreuz angeordnet sind, sondern jeweils in einer geraden Linie parallel zur Längsachse des Strommesswiderstands.

Nachteilig an diesem bekannten Strommesswiderstand ist jedoch der nicht optimale Temperaturkoeffizient, so dass die Messung temperaturabhängig ist.

Zum technischen Hintergrund der Erfindung ist auch hinzuweisen auf DE 10 2020 111 634 B3, EP 3 671 225 A1, US 2011/0057764 A1, DE 20 2013 011 960 U1, DE 10 2014 011 593 A1, US 2020/292588 A1, US 2017/307660 A1 und DE 11 2015 004 849 T5.

Der Erfindung liegt deshalb die Aufgabe zugrunde, einen entsprechend verbesserten Widerstand zu schaffen.

Diese Aufgabe wird durch einen erfindungsgemäßen Widerstand gemäß dem Hauptanspruch gelöst.

Der erfindungsgemäße Widerstand weist zunächst in Übereinstimmung mit dem eingangs beschriebenen bekannten Strommesswiderstand ein erstes Anschlussteil auf, das aus einem elektrisch leitfähigen Leitermaterial (z.B. Kupfer) besteht und dazu dient, den zu messenden elektrischen Strom in den Widerstand einzuleiten.

Darüber hinaus weist auch der erfindungsgemäße Widerstand in Übereinstimmung mit dem eingangs beschriebenen bekannten Strommesswiderstand ein zweites Anschlussteil auf, das aus einem elektrisch leitfähigen Leitermaterial (z.B. Kupfer) besteht und dazu dient, den elektrischen Strom wieder aus dem Widerstand auszuleiten.

Weiterhin hat auch der erfindungsgemäße Widerstand ein Widerstandselement, das aus einem niederohmigen Widerstandsmaterial (z.B. Manganin^{®}) besteht, wobei das Widerstandselement bezüglich der Hauptstromflussrichtung in dem Widerstand zwischen dem ersten Anschlussteil und dem zweiten Anschlussteil angeordnet ist, so dass der elektrische Strom im Betrieb durch das Widerstandselement fließt.

Ferner verfügt der erfindungsgemäße Widerstand über ein erstes Paar von Spannungsmesskontakten mit einem spannungsseitigen Spannungsmesskontakt zur Potentialmessung an dem ersten Anschlussteil einerseits und mit einem masseseitigen Spannungsmesskontakt zur Potentialmessung an dem zweiten Anschlussteil andererseits.

Weiterhin verfügt der erfindungsgemäße Widerstand in Übereinstimmung mit dem eingangs beschriebenen bekannten Strommesswiderstand auch über ein zweites Paar von Spannungsmesskontakten mit einem spannungsseitigen Spannungsmesskontakt zur Potentialmessung an dem ersten Anschlussteil einerseits und einem masseseitigen Spannungsmesskontakt zur Potentialmessung an dem zweiten Anschlussteil andererseits.

Bei dem eingangs beschriebenen bekannten Strommesswiderstand gemäß WO 2014/161624 A1 sind die Paare von Spannungsmesskontakten so angeordnet, dass keine Überkreuzmessung erfolgt, d.h. die Verbindungslinien zwischen den Spannungsmesskontakten der Paare verlaufen parallel zueinander. Dies hat jedoch bei dem bekannten Strommesswiderstand zur Folge, dass die Temperaturabhängigkeit der Messung nicht optimal ist.

Die Erfindung sieht nun im Gegensatz dazu vor, dass die beiden Paare von Spannungsmesskontakten über Kreuz angeordnet sind, so dass sich die Verbindungslinie der beiden Spannungsmesskontakte des ersten Paars von Spannungsmesskontakten mit der Verbindungslinie der beiden Spannungsmesskontakte des zweiten Paars von Spannungsmesskontakten in einer Aufsicht auf den Widerstand schneidet. Die Erfindung sieht also eine Überkreuzmessung an den verschiedenen Paaren von Spannungsmesskontakten vor.

Weiterhin ist zu erwähnen, dass die Erfindung nicht beschränkt ist auf einen Widerstand mit nur zwei Paaren von Spannungsmesskontakten. Es ist im Rahmen der Erfindung vielmehr auch möglich, dass eine größere Anzahl von Paaren von Spannungsmesskontakten vorgesehen ist, wie es auch bei dem eingangs beschriebenen bekannten Strommesswiderstand gemäß WO 2014/161624 A1 der Fall ist. Wichtig ist hierbei nur, dass sich die einzelnen Paare von Spannungsmesskontakten mit ihren Verbindungslinien kreuzen, wie es bereits vorstehend beschrieben wurde.

In einem bevorzugten Ausführungsbeispiel der Erfindung befindet sich in den beiden Anschlussteilen jeweils ein Einschnitt, wie es an sich aus dem Stand der Technik bekannt ist, wobei derartige Einschnitte auch als Stromschatten bezeichnet werden und dazu dienen, die elektrische Feldverteilung in dem Strommesswiderstand positiv zu beeinflussen. Die beiden Einschnitte in den gegenüberliegenden Anschlussteilen können hierbei entlang der Hauptstromflussrichtung in dem Widerstand den gleichen Abstand zu dem Widerstandselement aufweisen, was jedoch nicht zwingend erforderlich ist.

Weiterhin ist zu erwähnen, dass die beiden Einschnitte vorzugsweise auf derselben Seite des Widerstands angeordnet sind und somit von demselben Seitenrand des Widerstands ausgehen. Hierbei besteht die Möglichkeit, dass sich die beiden Einschnitte mindestens auf einem Teil ihrer Länge quer zu der Hauptstromflussrichtung in dem Widerstand erstrecken, um einen Stromschatten zu bilden, wie vorstehend bereits erwähnt wurde. Beispielsweise können sich die beiden Einschnitte zur Mitte hin bis in eine Tiefe erstecken, in der sich auch die Spannungsmesskontakte befinden.

Dies ist sinnvoll, damit die als Stromschatten dienenden Einschnitte die Spannungsmesskontakte entsprechend abschirmen.

Weiterhin ist zu erwähnen, dass die beiden Einschnitte ausgehend vom Seitenrand des Widerstands die gleiche Tiefe aufweisen können. Es besteht jedoch alternativ auch die Möglichkeit, dass die beiden Einschnitte in den beiden Anschlussteilen eine unterschiedliche Tiefe haben und sich somit unterschiedlich weit bis zur Mittelachse des Widerstands erstrecken.

Die vorstehend erwähnten Spannungsmesskontakte sind bezüglich der Hauptstromflussrichtung vorzugsweise zwischen dem Widerstandselement und dem jeweiligen Einschnitt angeordnet.

Weiterhin besteht im Rahmen der Erfindung die Möglichkeit, dass die beiden Anschlussteile quer zu der Hauptstromflussrichtung vorzugsweise die gleiche Breite aufweisen. Der erfindungsgemäße Widerstand kann also in einer Aufsicht rechteckig sein. Es besteht jedoch alternativ auch die Möglichkeit, dass die beiden Anschlussteile quer zu der Strumpfhauptstromflussrichtung eine unterschiedliche Breite aufweisen. So kann der erfindungsgemäße Widerstand in einer Aufsicht auch L-förmig sein.

Ferner ist zu erwähnen, dass der erfindungsgemäße Widerstand an der Seite mit den Einschnitten vorzugsweise einen durchgehenden, geraden Seitenrand ohne Knickstellen aufweist. Auf der den Einschnitten gegenüberliegenden Seite kann der Widerstand dagegen einen Seitenrand mit mindestens einer Knickstelle aufweisen. Diese Knickstelle kann sich beispielsweise in dem ersten Anschlussteil befinden, das dazu dient, den elektrischen Strom in den Widerstand einzuleiten. Die Breite des ersten Anschlussteils stromaufwärts vor der Knickstelle ist dann vorzugsweise größer als die Breite des ersten Anschlussteils stromabwärts hinter der Knickstelle.

Es wurde bereits vorstehend kurz erwähnt, dass der erfindungsgemäße Widerstand in einer Aufsicht L-förmig sein kann. Hierbei ist es vorteilhaft, wenn die Tiefe des Einschnittes in dem breiteren Anschlussteil kleiner ist als die Tiefe des Einschnitts in dem schmaleren Anschlussteil, da dies die elektrische Feldverteilung in dem Widerstand positiv beeinflusst.

Die Erfindung ermöglicht - wie bereits vorstehend kurz erwähnt wurde - eine Verbesserung des Temperaturverhaltens des Widerstands. Hierbei ist zu erwähnen, dass der erfindungsgemäße Widerstand zwischen den beiden Spannungsmesskontakten des ersten Paars einen temperaturabhängigen ersten Widerstandswert aufweist, während der Widerstand zwischen den beiden Spannungsmesskontakten des zweiten Paars einen temperaturabhängigen zweiten Widerstandswert aufweist. Die Überkreuzmessung gemäß der Erfindung ermöglicht es nun, dass diese beiden Widerstandswerte unabhängig von der Temperatur im Wesentlichen gleich sind und zwar mit einem Unterschied von weniger als ±20%, ±10 %, ±5 %, ±2 % oder ±1% innerhalb des gesamten Temperaturbereich von -70°C bis +170°C, -40°C bis +140°C, -10°C bis +110°C oder zumindest innerhalb des gesamten Temperaturbereich von +20°C bis +80°C.

Es wurde bereits vorstehend kurz erwähnt, dass das Leitermaterial der Anschlussteile Kupfer sein kann. Es besteht jedoch alternativ auch die Möglichkeit, dass es sich bei dem Leitermaterial der Anschlussteile um eine Kupferlegierung, Aluminium oder eine Aluminiumlegierung handelt.

Auch hinsichtlich des Widerstandsmaterials des Widerstandselements bestehen im Rahmen der Erfindung verschiedene Möglichkeiten. Beispielsweise kann das Widerstandsmaterial eine Kupferlegierung sein, insbesondere eine Kupfer-Mangan-Nickel Legierung. Beispiele hierfür sind die Widerstandslegierungen Manganin^{®} (CuMn12Ni), Zeranin^{®} (CuMn7Sn) oder Noventin^{®} (CuMnNi 25-10). Alternativ besteht die Möglichkeit, dass sich bei dem Widerstandsmaterial um eine NickelChrom-Legierung handelt, wie beispielsweise Isaohm^{®} (NiCr20Alsi). Ferner besteht auch die Möglichkeit, dass das Widerstandsmaterial eine Eisen-Chrom-Legierung ist, wie beispielsweise AluChrom^{®} (Fe70/Cr25/Al5).

Bei dem bevorzugten Ausführungsbeispiel der Erfindung ist das Widerstandselement elektrisch und mechanisch mit den beiden Anschlussteilen verbunden, beispielsweise durch eine Schweißverbindung, wobei sich eine Elektronenstrahlverschweißung besonders eignet, wie beispielsweise aus EP 0 605 800 A1 bekannt ist.

Ferner ist zu erwähnen, dass die Anschlussteile vorzugsweise auf gegenüberliegenden Seiten des Widerstandselements angeordnet sind. Es besteht jedoch alternativ auch die Möglichkeit, dass die Anschlussteile auf derselben Seite des Widerstandselements angeordnet sind, so dass Einleitung und Ausleitung des Stroms an derselben Seite des Widerstandselements erfolgen.

Darüber hinaus ist zu bemerken, dass die Anschlussteile und das Widerstandselement vorzugsweise plattenförmig sind, wobei die plattenförmigen Teile wahlweise eben oder gebogen sein können.

Allgemein ist zu erwähnen, dass das Widerstandsmaterial des Widerstandselements einen größeren spezifischen elektrischen Widerstand aufweist als das Leitermaterial der Anschlussteile. Beispielsweise kann das Widerstandsmaterial des Widerstandselements einen spezifischen elektrischen Widerstand von weniger als 1000 µΩcm, 500 µΩcm, 250 µΩcm, 100 µΩcm oder 50 µΩcm aufweisen.

Das Leitermaterial der Anschlussteile hat dagegen vorzugsweise einen spezifischen elektrischen Widerstand von weniger als 20 µΩcm, 10 µΩcm, 5 µΩcm oder 2 µΩcm.

Der Widerstand als Ganzes hat dagegen vorzugsweise einen Widerstandswert, der kleiner ist als 100 Ω, 10 Ω, 1 Ω, 100 mΩ, 10 mΩ, 1 mΩ, 100 µΩ, 10 µΩ oder 1 µΩ.

In den beiden Anschlussteilen kann sich bei dem erfindungsgemäßen Widerstand jeweils ein Stromanschluss befinden, um den Strom in den Widerstand einzuleiten bzw. aus dem Widerstand auszuleiten. Beispielsweise kann dieser Stromanschluss aus einer Bohrung in dem jeweiligen Anschlussteil bestehen.

Ferner ist zu erwähnen, dass der Widerstand bezüglich der Hauptstromflussrichtung wahlweise symmetrisch oder asymmetrisch ausgebildet sein kann.

Die vorstehend erwähnten Spannungsmesskontakte sind dagegen in dem Widerstand vorzugsweise bezüglich der Mittelachse des Widerstands außermittig angeordnet, beispielsweise im seitlichen Drittel oder Viertel des Widerstands, insbesondere auf der Seite der Einschnitte.

Vorstehend wurde der erfindungsgemäße Widerstand als einzelnes Bauteil beschrieben. Die Erfindung beansprucht jedoch auch Schutz für eine Messanordnung mit einem solchen Widerstand zur Strommessung.

Darüber hinaus weist die erfindungsgemäße Messanordnung eine Spannungsmesseinrichtung auf, die zwei Spannungsmesskanäle enthält, um an den beiden Paaren von Spannungsmesskontakten getrennt in den beiden Spannungsmesskanälen die Spannung zu messen.

Ferner verfügt die erfindungsgemäße Messanordnung vorzugsweise über eine Recheneinheit, um die Spannungsmesswerte in den beiden Spannungsmesskanälen auszuwerten. In einer Variante der Erfindung berechnet die Recheneinheit aus den beiden Spannungsmesswerten einen Mittelwert und berechnet dann den durch den Widerstand fließenden Strom aus diesem Mittelwert. In einer anderen Erfindungsvariante wird dagegen aus den beiden Spannungsmesswerten jeweils ein entsprechender Strommesswert gemäß dem Ohmschen Gesetz berechnet, wie es an sich aus dem Stand der Technik bekannt ist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.
Figur 1A zeigt einen herkömmlichen Strommesswiderstand gemäß dem Stand der Technik mit einer entsprechenden Messanordnung.
Figur 1B zeigt den Verlauf der relativen Widerstandsänderung des Strommesswiderstands gemäß Figur 1A in Abhängigkeit von der Temperatur.
Figur 2A zeigt einen erfindungsgemäßen Strommesswiderstand als Bestandteil einer entsprechenden Messanordnung.
Figur 2B zeigt die relative Widerstandsänderung in Abhängigkeit von der Temperatur für den Strommesswiderstand gemäß Figur 2A.
Figur 3A zeigt eine Abwandlung des Strommesswiderstands gemäß Figur 2A mit zwei seitlichen Einschnitten (Stromschatten).
Figur 3B zeigt wieder den Verlauf der relativen Widerstandsänderung für den Strommesswiderstand gemäß Figur 3A in Abhängigkeit von der Temperatur.
Figur 4A zeigt eine Abwandlung von Figur 3A mit einem L-förmigen Strommesswiderstand.
Figur 4B zeigt den Verlauf der relativen Widerstandsänderung in Abhängigkeit von der Temperatur für den Strommesswiderstand gemäß Figur 4A.
Figur 4C zeigt den Feldverlauf und die Äquipotentiallinien in dem Strommesswiderstand gemäß Figur 4A.
Figur 5 zeigt eine erfindungsgemäße Messanordnung in einer schematischen Darstellung.
Figur 6 zeigt eine Abwandlung von Figur 5.

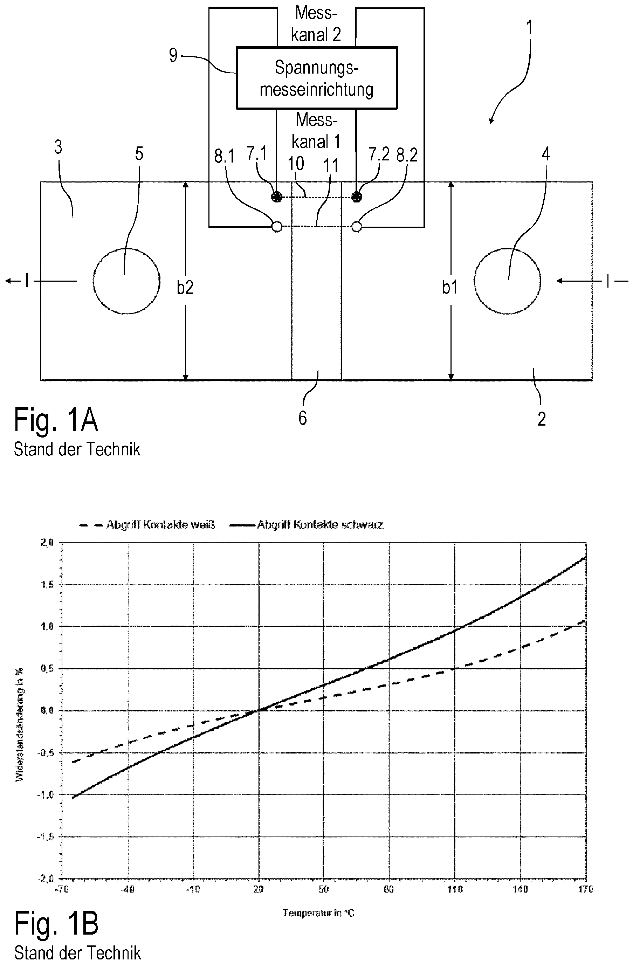

Im Folgenden wird nun zunächst die Zeichnung gemäß Figur 1A beschrieben, die einen herkömmlichen Strommesswiderstand 1 gemäß dem Stand der Technik darstellt.

Zunächst weist der herkömmliche Strommesswiderstand 1 ein plattenförmiges Anschlussteil 2 aus Kupfer auf, das dazu dient, einen zu messenden elektrischen Strom I in den Strommesswiderstand 1 einzuleiten.

Weiterhin weist der Strommesswiderstand 1 ein plattenförmiges Anschlussteil 3 aus Kupfer auf, das dazu dient, den elektrischen Strom I wieder aus dem Strommesswiderstand 1 auszuleiten.

Hierzu weisen die beiden plattenförmigen Anschlussteile 2, 3 jeweils eine Bohrung 4 bzw. 5 auf, an die beispielsweise eine Schraube angeschlossen werden kann, wie es an sich aus dem Stand der Technik bekannt ist.

In dem dargestellten Ausführungsbeispiel weisen die beiden Anschlussteile 2, 3 rechtwinklig zur Stromflussrichtung dieselbe Breite b1 bzw. b2 auf.

Zwischen den beiden Anschlussteilen 2, 3 befindet sich hierbei ein ebenfalls plattenförmiges Widerstandselement 6 aus einem Widerstandsmaterial (z.B. Manganin^{®}), wobei das Widerstandselement 6 an seinen Kanten durch eine Elektronenstrahlverschweißung mit den angrenzenden Anschlussteilen 2, 3 verbunden ist. Der zu messende elektrische Strom I wird also über das Anschlussteil 2 in den Strommesswiderstand 1 eingeleitet, fließt dann durch das Widerstandselement 6 und wird dann über das andere Anschlussteil 3 wieder aus dem Strommesswiderstand 1 ausgeleitet.

Weiterhin weist der Strommesswiderstand zwei Paare von Spannungsmesskontakten 7.1, 7.2 bzw. 8.1, 8.2 auf, um die über dem Widerstandselement 6 abfallende elektrische Spannung zu messen, die gemäß dem Ohmschen Gesetz ein Maß für den elektrischen Strom I bildet, der durch den Strommesswiderstand 1 fließt.

Darüber hinaus zeigt die Zeichnung eine Spannungsmesseinrichtung 9 mit zwei Spannungsmesskanälen, wobei der erste Spannungsmesskanal der Spannungsmesseinrichtung 9 mit den beiden Spannungsmesskontakten 7.1, 7.2 des ersten Paars verbunden ist, während der zweite Spannungsmesskanal der Spannungsmesseinrichtung 9 mit den beiden Spannungsmesskontakten 8.1, 8.2 des zweiten Paars verbunden ist. Die Spannungsmesseinrichtung 9 kann die beiden Spannungsmesswerte also getrennt voneinander messen.

Hierbei ist zu erwähnen, dass die beiden Paare von Spannungsmesskontakten 7.1, 7.2 bzw. 8.1, 8.2 nicht über Kreuz angeordnet sind, sondern jeweils parallel zur Hauptstromflussrichtung in dem Strommesswiderstand 1 nebeneinander angeordnet sind. So zeigt die Zeichnung eine Verbindungslinie 10 zwischen den Spannungsmesskontakten 7.1, 7.2 des ersten Spannungsmesskanals und eine weitere Verbindungslinie 11 zwischen den beiden Spannungsmesskontakten 8.1, 8.2 des zweiten Spannungsmesskanals. Die beiden Verbindungslinien 10, 11 verlaufen hierbei exakt parallel zueinander.

Bei dieser Anordnung der Spannungsmesskontakte 7.1, 7.2, 8.1, 8.2 weist der Strommesswiderstand 1 eine relativ große Temperaturabhängigkeit auf, wie aus Figur 1B ersichtlich ist. So zeigt die durchgezogene Linie die relative Widerstandsänderung in Abhängigkeit von der Temperatur zwischen den beiden Spannungsmesskontakten 7.1, 7.2 des ersten Messkanals. Die gestrichelte Linie zeigt dagegen die relative Widerstandsänderung in Abhängigkeit von der Temperatur zwischen den beiden Spannungsmesskontakten 8.1, 8.2 des zweiten Messkanals.

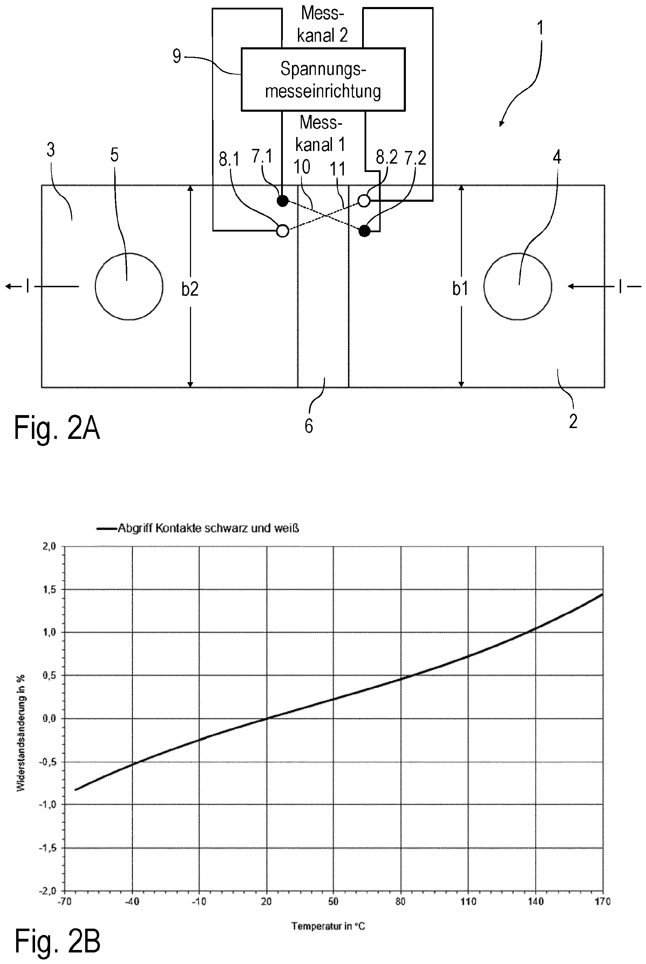

Die Figuren 2A und 2B zeigen entsprechende Darstellungen für einen erfindungsgemäßen Strommesswiderstand 1, wobei diese Darstellungen weitgehend mit der vorstehend beschriebenen Darstellung gemäß den Figuren 1A bzw. 1B übereinstimmen, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses erfindungsgemäßen Ausführungsbeispiels besteht darin, dass sich die beiden Verbindungslinien 10, 11 zwischen den Spannungsmesskontakten 7.1, 7.2 einerseits und zwischen den Spannungsmesskontakten 8.1, 8.2 andererseits in der Aufsicht kreuzen. Dies hat zur Folge, dass die Temperaturabhängigkeit des Widerstandswerts bei den beiden Paaren von Spannungsmesskontakten 7.1, 7.2 bzw. 8.1, 8.2 die gleiche ist, wie aus Figur 2B ersichtlich ist.

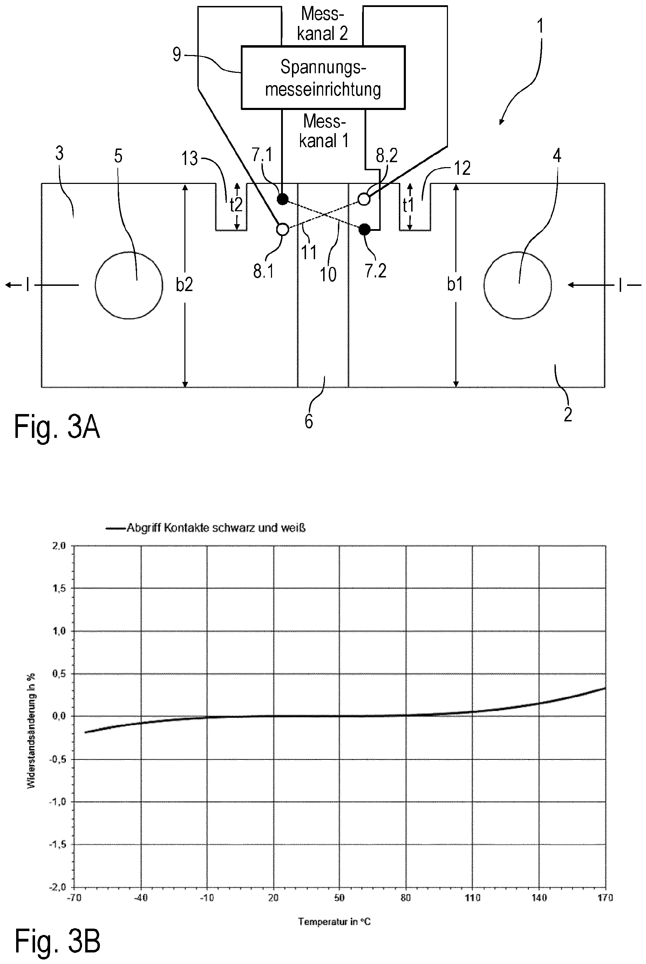

Die Figuren 3A und 3B zeigen wieder eine Abwandlung zu den vorstehenden Figuren, so dass zur Vermeidung von Wiederholungen auf die vorstehende Beschreibung verwiesen wird, wobei für entsprechende Einzelheiten dieselben Bezugszeichen verwendet werden.

Eine Besonderheit besteht hierbei darin, dass der Strommesswiderstand 1 in den beiden Anschlussteilen 2, 3 jeweils einen Einschnitt 12 bzw. 13 aufweist, der auch als Stromschatten bezeichnet wird und die elektrische Feldverteilung in dem Strommesswiderstand eins positiv beeinflusst.

Die beiden Einschnitte 12, 13 gehen hierbei jeweils von demselben Seitenrand des Stromesswiderstands 1 aus und erstrecken sich rechtwinklig zur Hauptstromflussrichtung in dem Strommesswiderstand 1 bis in eine Tiefe t1 bzw. t2, wobei die beiden Tiefen t1, t2 in diesem Ausführungsbeispiel gleich groß sind.

Die Spannungsmesskontakte 7.1, 8.1 liegen hierbei bezüglich der Hauptstromflussrichtung in dem Strommesswiderstand 1 zwischen dem Widerstandselement 6 und dem Einschnitt 13.

Die anderen Spannungsmesskontakte 7.2, 8.2 liegen dagegen bezüglich der Hauptstromflussrichtung in dem Strommesswiderstand 1 zwischen dem Widerstandselement 6 und dem anderen Einschnitt 12.

Die Einschnitte 12, 13 verringern die Temperaturabhängigkeit der Messung, wie unmittelbar aus einem Vergleich von Figur 3B mit Figur 2B ersichtlich ist.

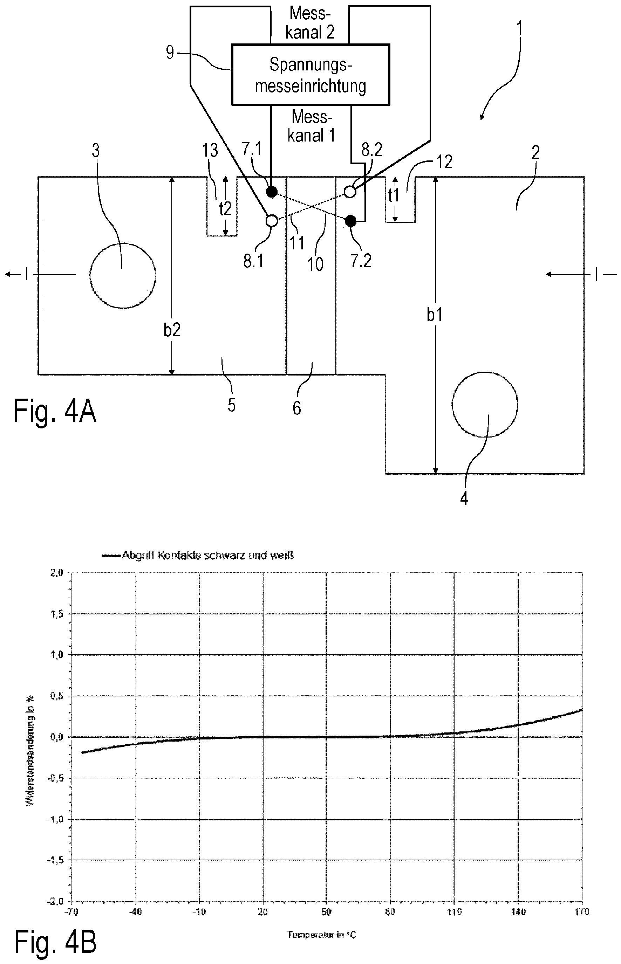

Die Figuren 4A und 4B zeigen eine weitere Abwandlung des vorstehend beschriebenen Strommesswiderstands 1, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit des Stromesswiderstands 1 besteht in diesem Ausführungsbeispiel darin, dass der Strommesswiderstand 1 in der Aufsicht L-förmig ist. Dies bedeutet, dass die Breite b1 bei dem Anschlussteil 2 wesentlich größer ist als die Breite b2 bei dem anderen Anschlussteil 3.

Darüber hinaus ist die Tiefe t1 des Einschnitts 12 deutlich kleiner als die Tiefe t2 des anderen Einschnitts 13.

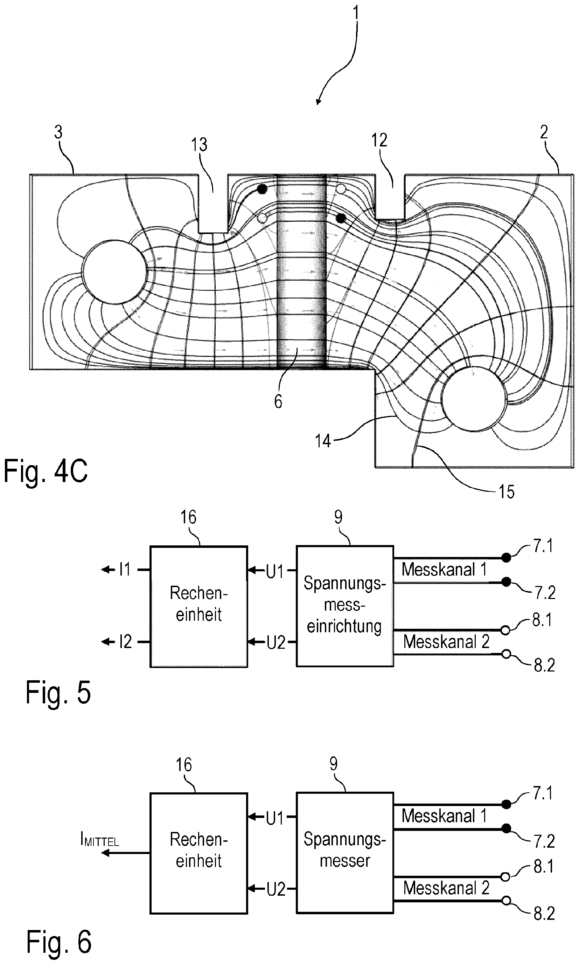

Figur 4C zeigt den Verlauf von elektrischen Feldlinien 14 und Äquipotentiallinien 15 in dem Strommesswiderstand 1 gemäß Figur 4A.

Figur 5 zeigt eine schematische Darstellung einer erfindungsgemäßen Messanordnung mit der Spannungsmesseinrichtung 9 zur Spannungsmessung über die beiden Messkanäle. Hierbei erzeugt die Spannungsmesseinrichtung 9 zwei Spannungsmesswerte U1, U2, die getrennt voneinander an eine Recheneinheit 16 ausgegeben werden. Die Recheneinheit 16 berechnet dann entsprechend dem Ohmschen Gesetz zwei Strommesswerte I1, I2 für den elektrischen Strom I, der durch den Strommesswiderstand 1 fließt.

Bei dem abgewandelten Ausführungsbeispiel gemäß Figur 6 berechnet die Recheneinheit 16 aus den beiden Spannungsmesswerte U1, U2 einen Mittelwert und gibt dann einen gemittelten Stromwert I_{MITTEL} aus.

### Bezugszeichenliste

- 1: Strommesswiderstand
- 2: Anschlussteil zum Einleiten des Stroms in den Strommesswiderstand
- 3: Anschlussteil zum Ausleiten des Stroms aus dem Strommesswiderstand
- 4: Bohrung in dem Anschlussteil zum Einleiten des Stroms in den Strommesswiderstand
- 5: Bohrung in dem Anschlussteil zum Ausleiten des Stroms aus dem Strommesswiderstand
- 6: Widerstandselement
- 7.1, 7.2: Spannungsmesskontakte für Messkanal 1
- 8.2, 8.2: Spannungsmesskontakte für Messkanal 2
- 9: Spannungsmesseinrichtung
- 10: Verbindungslinie der Spannungsmesskontakte für Messkanal 1
- 11: Verbindungslinie der Spannungsmesskontakte für Messkanal 2
- 12: Einschnitt (Stromschatten) in dem Anschlussteil zum Einleiten des Stroms in den Strommesswiderstand
- 13: Einschnitt (Stromschatten) in dem Anschlussteil zum Ausleiten des Stroms aus dem Strommesswiderstand
- 14: Elektrische Feldlinien
- 15: Äquipotentiallinien in dem Strommesswiderstand
- 16: Recheneinheit
- t1: Tiefe des Einschnitts in dem Anschlussteil zum Einleiten des Stroms in den Strommesswiderstand
- t2: Tiefe des Einschnitts in dem Anschlussteil zum Ausleiten des Stroms aus dem Strommesswiderstand
- U1: Spannungsmesswert in Messkanal 1
- U2: Spannungsmesswert in Messkanal 2
- b1: Breite des Anschlussteils zum Ausleiten des Stroms aus dem Strommesswiderstand
- b2: Breite des Anschlussteils zum Ausleiten des Stroms aus dem Strommesswiderstand
- I: Strom durch den Strommesswiderstand
- I1: Stromwert, berechnet aus Messkanal 1
- I2: Stromwert, berechnet aus Messkanal 2
- I_{MITTEL}: Gemittelter Stromwert

## Patentansprüche

1. Widerstand (1), insbesondere niederohmiger Strommesswiderstand (1), mit
a) einem ersten Anschlussteil (2) aus einem elektrisch leitfähigen Leitermaterial zum Einleiten eines elektrischen Stroms (I) in den Widerstand (1),
b) einem zweiten Anschlussteil (3) aus einem elektrisch leitfähigen Leitermaterial zum Ausleiten des elektrischen Stroms (I) aus dem Widerstand (1),
c) einem Widerstandselement (6) aus einem niederohmigen Widerstandsmaterial, wobei das Widerstandselement (6) bezüglich einer Hauptstromflussrichtung zwischen dem ersten Anschlussteil (2) und dem zweiten Anschlussteil (3) angeordnet ist und im Betrieb von dem elektrischen Strom (I) durchflossen wird,
d) einem ersten Paar von Spannungsmesskontakten (7.1, 7.2) mit einem spannungsseitigen Spannungsmesskontakt (7.2) zur Potentialmessung an dem ersten Anschlussteil (2) einerseits und einem masseseitigen Spannungsmesskontakt (7.1) zur Potentialmessung an dem zweiten Anschlussteil (3) andererseits, und
e) einem zweiten Paar von Spannungsmesskontakten (8.1, 8.2) mit einem spannungsseitigen Spannungsmesskontakt (8.2) zur Potentialmessung an dem ersten Anschlussteil (2) einerseits und einem masseseitigen Spannungsmesskontakt (8.1) zur Potentialmessung an dem zweiten Anschlussteil (3) andererseits,
**dadurch gekennzeichnet,**
f) **dass** die beiden Paare von Spannungsmesskontakten (7.1, 7.2, 8.1, 8.2) über Kreuz angeordnet sind, so dass sich eine Verbindungslinie (10) der beiden Spannungsmesskontakte (7.1, 7.2) des ersten Paars von Spannungsmesskontakten (7.1, 7.2, 8.1, 8.2) mit einer Verbindungslinie (11) der beiden Spannungsmesskontakte (8.1, 8.2) des zweiten Paars von Spannungsmesskontakten (7.1, 7.2, 8.1, 8.2) in einer Aufsicht auf den Widerstand (1) schneidet.

2. Widerstand (1) nach Anspruch 1, **gekennzeichnet durch**
a) einen seitlichen ersten Einschnitt (12) in dem ersten Anschlussteil (2) und
b) einen seitlichen zweiten Einschnitt (13) in dem zweiten Anschlussteil (3),
c) wobei die beiden Einschnitte (12, 13) optional den gleichen Abstand zu dem Widerstandselement (6) haben.

3. Widerstand (1) nach Anspruch 2, **dadurch gekennzeichnet,**
a) **dass** die beiden Einschnitte (12, 13) auf derselben Seite des Widerstands (1) angeordnet sind und vom Seitenrand des Widerstands (1) ausgehen,
b) **dass** sich die beiden Einschnitte (12, 13) mindestens auf einem Teil ihrer Länge quer zu der Hauptstromflussrichtung in dem Widerstand (1) erstrecken, um einen Stromschatten zu bilden.
c) **dass** sich die beiden Einschnitte (12, 13) zur Mitte hin optional bis in eine Tiefe (t1, t2) erstrecken, in der sich die Spannungsmesskontakte (7.1, 7.2, 8.1, 8.2) befinden.

4. Widerstand (1) nach Anspruch 2 oder 3, **dadurch gekennzeichnet, dass** die beiden Einschnitte (12, 13) quer zu der Hauptstromflussrichtung in dem Widerstand (1) eine unterschiedliche Tiefe (t1, t2) aufweisen.

5. Widerstand (1) nach einem der Ansprüche 2 bis 4, **dadurch gekennzeichnet,**
a) **dass** die spannungsseitigen Spannungsmesskontakte (7.2, 8.2) der beiden Paare von Spannungsmesskontakten (7.1, 7.2, 8.1, 8.2) bezüglich der Hauptstromflussrichtung in dem ersten Anschlussteil (2) zwischen dem Widerstandselement (6) und dem ersten Einschnitt (12) angeordnet sind, und
b) **dass** die masseseitigen Spannungsmesskontakte (7.1, 8.1) der beiden Paare von Spannungsmesskontakten (7.1, 7.2, 8.1, 8.2) bezüglich der Hauptstromflussrichtung in dem zweiten Anschlussteil (3) zwischen dem Widerstandselement (6) und dem zweiten Einschnitt (13) angeordnet sind.

6. Widerstand (1) nach einem der vorhergehenden Ansprüche, **dadurch gekennzeichnet, dass** die beiden Anschlussteile (2, 3) quer zu der Hauptstromflussrichtung eine unterschiedliche Breite (b1, b2) aufweisen.

7. Widerstand (1) nach Anspruch 6, **dadurch gekennzeichnet,**
a) **dass** der Widerstand (1) an der Seite mit den Einschnitten (12, 13) einen durchgehenden geraden Seitenrand ohne Knickstellen aufweist, und
b) **dass** der Widerstand (1) auf der Seite gegenüber den Einschnitten einen Seitenrand mit mindestens einer Knickstelle aufweist,
c) **dass** sich die Knickstelle optional in dem ersten Anschlussteil (2) befindet, so dass die Breite (b1) des ersten Anschlussteils (2) stromaufwärts vor der Knickstelle größer ist als die Breite (b2) stromabwärts hinter der Knickstelle.

8. Widerstand (1) nach Anspruch 6 oder 7, **dadurch gekennzeichnet, dass** die Tiefe (t1) des Einschnitts (12) in dem breiteren Anschlussteil (2) kleiner ist als die Tiefe (t2) des Einschnitts (13) in dem schmaleren Anschlussteil (3).

9. Widerstand (1) nach einem der vorhergehenden Ansprüche, **dadurch gekennzeichnet,**
a) **dass** der Widerstand (1) zwischen den beiden Spannungsmesskontakten (7.1, 7.2) des ersten Paars einen temperaturabhängigen ersten Widerstandswert aufweist,
b) **dass** der Widerstand (1) zwischen den beiden Spannungsmesskontakten (8.1, 8.2) des zweiten Paars einen temperaturabhängigen zweiten Widerstandswert aufweist,
c) **dass** die beiden Widerstandswerte unabhängig von der Temperatur im Wesentlichen gleich sind,
c1) insbesondere im gesamten Temperaturbereich von -70° bis +170°C, -40°C bis +140°C, -10°C bis + 110°C, +20° bis +80°,
c2) insbesondere mit einem Unterschied von weniger als ±20%, ±10%, ±5%, ±2% oder ±1%.

10. Widerstand (1) nach einem der vorhergehenden Ansprüche, **dadurch gekennzeichnet,**
a) **dass** das Leitermaterial der Anschlussteile (2, 3) optional Kupfer oder eine Kupferlegierung ist,
b) **dass** das Leitermaterial der Anschlussteile (2, 3) optional Aluminium oder eine Aluminiumlegierung ist,
c) **dass** das Widerstandsmaterial des Widerstandselements (6) optional eine Kupferlegierung ist, insbesondere eine Kupfer-Mangan-Nickel-Legierung, insbesondere CuMn12Ni, Cu84Ni4Mn2, CuMn7Sn oder CuMnNi 25-10,
d) **dass** das Widerstandsmaterial des Widerstandselements (6) optional eine Nickel-Chrom-Legierung ist, insbesondere NiCr20AlSi,
e) **dass** das Widerstandsmaterial des Widerstandselements (6) optional eine Eisen-Chrom-Legierung ist, insbesondere Fe70/Cr25/Al5,
f) **dass** das Widerstandselement (6) des Widerstandselements (6) optional elektrisch und mechanisch mit den beiden Anschlussteilen (2, 3) verbunden ist, insbesondere durch eine Schweißverbindung, insbesondere durch eine Elektronenstrahlverschweißung,
g) **dass** die beiden Anschlussteile (2, 3) optional auf gegenüberliegenden Seiten des Widerstandselements (6) angeordnet sind,
h) **dass** die Anschlussteile (2, 3) und/oder das Widerstandselement (6) optional plattenförmig sind,
i) **dass** die Anschlussteile (2, 3) und/oder das Widerstandselement (6) optional eben oder gebogen sind,
j) **dass** das Widerstandsmaterial des Widerstandselements (6) vorzugsweise einen größeren spezifischen elektrischen Widerstand aufweist als das Leitermaterial der Anschlussteile (2, 3),
k) **dass** das Widerstandsmaterial des Widerstandselements (6) optional einen spezifischen elektrischen Widerstand von weniger als 1000 µΩcm, 500 µΩcm, 250 µΩcm, 100 µΩcm oder 50 µΩcm aufweist,
l) **dass** das Leitermaterial der Anschlussteile (2, 3) optional einen spezifischen elektrischen Widerstand von weniger als 20 µΩcm, 10 µΩcm, 5 µΩcm oder 2 µΩcm aufweist,
m) **dass** der Widerstand (1) als Ganzes optional einen Widerstandswert aufweist, der kleiner ist als 100 Ω, 10 Ω, 1 Ω, 100 mΩ, 10 mΩ, 1 mΩ, 100 µΩ, 10 µΩ oder 1 µΩ,
n) **dass** die beiden Anschlussteile (2, 3) optional jeweils einen Stromanschluss (4, 5) aufweisen, um den Strom (I) in den Widerstand (1) einzuleiten bzw. aus dem Widerstand (1) auszuleiten, insbesondere in Form jeweils einer Bohrung (4, 5) in den Anschlussteilen (2, 3),
o) **dass** der Widerstand (1) optional bezüglich der Hauptstromflussrichtung asymmetrisch ist,
p) **dass** die Spannungsmesskontakte (7.1, 7.2, 8.1, 8.2) in dem Widerstand (1) bezüglich der Hauptstromflussrichtung außermittig angeordnet sind, insbesondere im seitlichen Drittel oder Viertel des Widerstands (1), insbesondere auf der Seite der Einschnitte.

11. Messanordnung, insbesondere zur Strommessung, mit
a) einem Widerstand (1) nach einem der vorhergehenden Ansprüche, insbesondere als niederohmiger Strommesswiderstand (1), und
b) einer Spannungsmesseinrichtung (9) mit
b1) einem ersten Spannungsmesskanal zur Messung der Spannung an dem ersten Paar (7.1, 7.2) von Spannungsmesskontakten des Widerstands (1), und
b2) einem zweiten Spannungsmesskanal zur Messung der Spannung an dem zweiten Paar (8.1, 8.2) von Spannungsmesskontakten des Widerstands (1).

12. Messanordnung nach Anspruch 11, **gekennzeichnet durch** eine Recheneinheit, die
a) aus den in den beiden Messkanälen gemessenen Spannungsmesswerten (U1, U2) gemäß dem Ohmschen Gesetz zwei Strommesswerte (I1, I2) berechnet, die jeweils den Strom (I) wiedergeben, der **durch** den Widerstand (1) fließt, wobei die beiden Stromesswerte (I1, I2) redundant sind, oder
b) aus den in den beiden Messkanälen gemessenen Spannungsmesswerten (U1, U2) gemäß dem Ohmschen Gesetz einen gemittelten Strommesswert (I_{MITTEL}) berechnet, der den Strom (I) wiedergibt, der **durch** den Widerstand (1) fließt.

## Claims

1. Resistor (1), in particular a low-resistance current-sensing resistor (1), having
a) a first connection part (2) made of an electrically conductive conductor material for introducing an electric current (I) into the resistor (1),
b) a second connection part (3) made of an electrically conductive conductor material for conducting the electric current (I) out of the resistor (1),
c) a resistor element (6) made of a low-resistance resistor material, said resistor element (6) being arranged between said first connection part (2) and said second connection part (3) with respect to a main current flow direction and being traversed by said electric current (I) during operation,
d) a first pair of voltage measuring contacts (7.1, 7.2) with a voltage measuring contact (7.2) on the voltage-side for potential measurement at the first connection part (2) on the one hand and a voltage measuring contact (7.1) on the ground-side for potential measurement at the second connection part (3) on the other hand, and
e) a second pair of voltage measuring contacts (8.1, 8.2) with a voltage-side voltage measuring contact (8.2) for potential measurement at the first connection part (2) on the one hand and a ground-side voltage measuring contact (8.1) for potential measurement at the second connection part (3) on the other hand,
**characterized in**
f) **that** the two pairs of voltage measuring contacts (7.1, 7.2, 8.1, 8.2) are arranged crosswise so that a connection line (10) of the two voltage measuring contacts (7.1, 7.2) of the first pair of voltage measuring contacts (7.1, 7.2, 8.1, 8.2) intersects with a connection line (11) of the two voltage measuring contacts (8.1, 8.2) of the second pair of voltage measuring contacts (7.1, 7.2, 8.1, 8.2) in a top view of the resistor (1).

2. Resistor (1) according to claim 1, **characterized by**
a) a lateral first cut (12) in the first connection part (2) and
b) a lateral second cut (13) in the second connection part (3),
c) wherein the two cuts (12, 13) optionally have the same distance to the resistor element (6).

3. Resistor (1) according to claim 2, **characterized in,**
a) **that** the two cuts (12, 13) are arranged on the same side of the resistor (1) and extend from the side edge of the resistor (1),
b) **that** the two cuts (12, 13) extend transversely to the main current flow direction in the resistor (1) over at least part of their length to form a current shadow,
c) **that** the two cuts (12, 13) optionally extend towards the centre up to a depth (t1, t2) at which the voltage measuring contacts (7.1, 7.2, 8.1, 8.2) are located.

4. Resistor (1) according to claim 2 or 3, **characterized in that** the two cuts (12, 13) have a different depth (t1, t2) transverse to the main current flow direction in the resistor (1).

5. Resistor (1) according to one of claims 2 to 4, **characterized in**
a) **that** the voltage-side voltage-measuring contacts (7.2, 8.2) of the two pairs of voltage-measuring contacts (7.1, 7.2, 8.1, 8.2) are arranged with respect to the main current flow direction in the first connection part (2) between the resistor element (6) and the first cut (12), and
b) **that** the ground-side voltage measuring contacts (7.1, 8.1) of the two pairs of voltage measuring contacts (7.1, 7.2, 8.1, 8.2) are arranged with respect to the main current flow direction in the second connection part (3) between the resistor element (6) and the second cut (13).

6. Resistor (1) according to one of the preceding claims, **characterized in that** the two connection parts (2, 3) have a different width (b1, b2) transverse to the main current flow direction.

7. Resistor (1) according to claim 6, **characterized in,**
a) **that** the resistor (1) comprises, on the side with the cuts (12, 13), a continuous straight side edge without kinks, and
b) **that** the resistor (1) comprises a side edge with at least one kink on the side opposite the cuts,
c) **that** the kink is optionally located in the first connection part (2), so that the width (b1) of the first connection part (2) upstream of the kink is greater than the width (b2) downstream of the kink.

8. Resistor (1) according to claim 6 or 7, **characterized in that** the depth (t1) of the cut (12) in the wider connection part (2) is smaller than the depth (t2) of the cut (13) in the narrower connection part (3).

9. Resistor (1) according to any one of the preceding claims, **characterized in,**
a) **that** the resistor (1) between the two voltage measuring contacts (7.1, 7.2) of the first pair has a temperature-dependent first resistance value,
b) **that** the resistor (1) between the two voltage measuring contacts (8.1, 8.2) of the second pair has a temperature-dependent second resistance value,
c) **that** the two resistance values are substantially the same irrespective of the temperature,
c1) in particular in the entire temperature range from -70° to +170°C, -40°C to +140°C, -10°C to +110°C, +20° to +80°,
c2) in particular with a difference of less than ±20%, ±10%, ±5%, ±2% or ±1%.

10. Resistor (1) according to any one of the preceding claims, **characterized in,**
a) **that** the conductor material of the connection parts (2, 3) is optionally copper or a copper alloy,
b) **that** the conductor material of the connection parts (2, 3) is optionally aluminium or an aluminium alloy,
c) **that** the resistor material of the resistor element (6) is optionally a copper alloy, in particular a copper-manganese-nickel alloy, in particular CuMn12Ni, Cu84Ni4Mn2, CuMn7Sn or CuMnNi 25-10,
d) **that** the resistor material of the resistor element (6) is optionally a nickel-chromium alloy, in particular NiCr20AISi,
e) **that** the resistor material of the resistor element (6) is optionally an iron-chromium alloy, in particular Fe70/Cr25/AI5,
f) **that** the resistor element (6) of the resistor element (6) is optionally electrically and mechanically connected to the two connection parts (2, 3), in particular by a welded connection, in particular by electron beam welding,
g) **that** the two connection parts (2, 3) are optionally arranged on opposite sides of the resistor element (6),
h) **that** the connection parts (2, 3) and/or the resistor element (6) are optionally plate-shaped,
i) **that** the connection parts (2, 3) and/or the resistor element (6) are optionally flat or curved,
j) **that** the resistor material of the resistor element (6) preferably has a greater specific electrical resistance than the conductor material of the connection parts (2, 3),
k) **that** the resistor material of the resistor element (6) optionally has a specific electrical resistance of less than 1000 µΩcm, 500 µΩcm, 250 µΩcm, 100 µΩcm or 50 µΩcm,
l) **that** the conductor material of the connection parts (2, 3) optionally has a specific electrical resistance of less than 20 µΩcm, 10 µΩcm, 5 µΩcm or 2 µΩcm,
m) **that** the resistor (1) as a whole optionally has a resistance value which is less than 100 Ω, 10 Ω, 1 Ω, 100 mΩ, 10 mΩ, 1 mΩ, 100 µΩ, 10 µΩ or 1 µΩ,
n) **that** the two connection parts (2, 3) optionally each have a current connection (4, 5) for introducing the current (I) into the resistor (1) or discharging it from the resistor (1), in particular in the form of a hole (4, 5) in each of the connection parts (2, 3),
o) **that** the resistor (1) is optionally asymmetrical with respect to the main current flow direction,
p) **that** the voltage measuring contacts (7.1, 7.2, 8.1, 8.2) in the resistor (1) are arranged off-centre with respect to the main current flow direction, in particular in the lateral third or quarter of the resistor (1), in particular on the side of the cuts.

11. Measuring arrangement, in particular for current measurement, with
a) a resistor (1) according to one of the preceding claims, in particular as a low-resistance current-sensing resistor (1), and
b) a voltage measuring device (9) with
b1) a first voltage measuring channel for measuring the voltage at the first pair (7.1, 7.2) of voltage measuring contacts of the resistor (1), and
b2) a second voltage measuring channel for measuring the voltage at the second pair (8.1, 8.2) of voltage measuring contacts of the resistor (1).

12. Measuring arrangement according to claim 11, **characterized by** a computing unit which
a) calculates two current measurement values (I1, I2) from the voltage measurement values (U1, U2) measured in the two measurement channels in accordance with Ohm's law, which in each case represent the current (I) flowing through the resistor (1), the two current measurement values (I1, I2) being redundant, or
b) calculates an averaged current measurement value (I_{AVERAGE}) from the voltage measurement values (U1, U2) measured in the two measurement channels according to Ohm's law, which represents the current (I) flowing through the resistor (1).

## Revendications

1. Résistance (1), en particulier résistance de mesure de courant de basse impédance (1), avec
a) une première partie de raccordement (2) composée d'un matériau conducteur électroconducteur pour introduire un courant électrique (I) dans la résistance (1),
b) une deuxième partie de raccordement (3) composée d'un matériau conducteur électroconducteur pour faire sortir le courant électrique (I) de la résistance (1),
c) un élément de résistance (6) composé d'un matériau de résistance de basse impédance, dans laquelle l'élément de résistance (6) est disposé par rapport à une direction de flux de courant principale entre la première partie de raccordement (2) et la deuxième partie de raccordement (3) et est traversé par le courant électrique (I) pendant le fonctionnement,
d) une première paire de contacts de mesure de tension (7.1, 7.2) avec un contact de mesure de tension (7.2) côté tension pour la mesure de potentiel sur la première partie de raccordement (2) d'une part et un contact de mesure de tension (7.1) côté masse pour la mesure de potentiel sur la deuxième partie de raccordement (3) d'autre part, et
e) une deuxième paire de contacts de mesure de tension (8.1, 8.2) avec un contact de mesure de tension (8.2) côté tension pour la mesure de potentiel sur la première partie de raccordement (2) d'une part et un contact de mesure de tension (8.1) côté masse pour la mesure de potentiel sur la deuxième partie de raccordement (3) d'autre part,
**caractérisée en ce**
f) **que** les deux paires de contacts de mesure de tension (7.1, 7.2, 8.1, 8.2) sont disposées en croix, de sorte qu'une ligne de liaison (10) des deux contacts de mesure de tension (7.1, 7.2) de la première paire de contacts de mesure de tension (7.1, 7.2, 8.1, 8.2) coupe une ligne de liaison (11) des deux contacts de mesure de tension (8.1, 8.2) de la deuxième paire de contacts de mesure de tension (7.1, 7.2, 8.1, 8.2) dans une vue de dessus de la résistance (1).

2. Résistance (1) selon la revendication 1, **caractérisée par**
a) une première encoche latérale (12) dans la première partie de raccordement (2) et
b) une deuxième encoche latérale (13) dans la deuxième partie de raccordement (3),
c) dans laquelle les deux encoches (12, 13) possèdent éventuellement la même distance par rapport à l'élément de résistance (6).

3. Résistance (1) selon la revendication 2, **caractérisée en ce**
a) **que** les deux encoches (12, 13) sont disposées sur le même côté de la résistance (1) et partent du bord latéral de la résistance (1),
b) **que** les deux encoches (12, 13) s'étendent au moins sur une partie de sa longueur transversalement par rapport à la direction de flux de courant principale dans la résistance (1), afin de former un courant d'ombre,
c) **que** les deux encoches (12, 13) s'étendent en direction du centre éventuellement jusque dans une profondeur (t1, t2) dans laquelle les contacts de mesure de tension (7.1, 7.2, 8.1, 8.2) se trouvent.

4. Résistance (1) selon la revendication 2 ou 3, **caractérisée en ce que** les deux encoches (12, 13) transversalement par rapport à la direction de flux de courant principale dans la résistance (1) présentent une profondeur (t1, t2) différente.

5. Résistance (1) selon l'une quelconque des revendications 2 à 4, **caractérisée en ce**
a) **que** les contacts de mesure de tension (7.2, 8.2) côté tension des deux paires de contacts de mesure de tension (7.1, 7.2, 8.1, 8.2) par rapport à la direction de flux de courant principale dans la première partie de raccordement (2) sont disposés entre l'élément de résistance (6) et la première encoche (12), et
b) **que** les contacts de mesure de tension (7.1, 8.1) côté masse des deux paires de contacts de mesure de tension (7.1, 7.2, 8.1, 8.2) par rapport à la direction de flux de courant principale dans la deuxième partie de raccordement (3) sont disposés entre l'élément de résistance (6) et la deuxième encoche (13).

6. Résistance (1) selon l'une quelconque des revendications précédentes, **caractérisée en ce que** les deux parties de raccordement (2, 3) transversalement par rapport à la direction de flux de courant principale présentent une largeur (b1, b2) différente.

7. Résistance (1) selon la revendication 6, **caractérisée en ce**
a) **que** la résistance (1) présente sur le côté avec les encoches (12, 13) un bord latéral droit continu sans points d'inflexion, et
b) **que** la résistance (1) présente sur le côté par rapport aux encoches un bord latéral avec au moins un point d'inflexion,
c) **que** le point d'inflexion se trouve éventuellement dans la première partie de raccordement (2), de sorte que la largeur (b1) de la première partie de raccordement (2) en amont devant le point d'inflexion est plus grande que la largeur (b2) en aval derrière le point d'inflexion.

8. Résistance (1) selon la revendication 6 ou 7, **caractérisée en ce que** la profondeur (t1) de l'encoche (12) dans la partie de raccordement (2) plus large est inférieure à la profondeur (t2) de l'encoche (13) dans la partie de raccordement (3) plus étroite.

9. Résistance (1) selon l'une quelconque des revendications précédentes, caractérisée en ce
a) que la résistance (1) présente entre les deux contacts de mesure de tension (7.1, 7.2) de la première paire une première valeur de résistance dépendant de la température,
b) que la résistance (1) entre les deux contacts de mesure de tension (8.1, 8.2) de la deuxième paire présente une deuxième valeur de résistance dépendant de la température,
c) que les deux valeurs de résistance indépendamment de la température sont sensiblement identiques,
c1) en particulier dans toute la plage de températures de -70 ° à +170 °C, -40 °C à +140 °C, -10 °C à +110 °C, +20 ° à +80 °,
c2) en particulier avec une différence inférieure à ±20 %, ±10 %, ±5 %, ±2 % ou ±1 %.

10. Résistance (1) selon l'une quelconque des revendications précédentes, **caractérisée en ce**
a) **que** le matériau conducteur des parties de raccordement (2, 3) est éventuellement du cuivre ou un alliage de cuivre,
b) **que** le matériau conducteur des parties de raccordement (2, 3) est éventuellement de l'aluminium ou un alliage d'aluminium,
c) **que** le matériau de résistance de l'élément de résistance (6) est éventuellement un alliage de cuivre, en particulier un alliage cuivre-manganèse-nickel, en particulier CuMn12Ni, Cu84Ni4Mn2, CuMn7Sn ou CuMnNi 25-10,
d) **que** le matériau de résistance de l'élément de résistance (6) est éventuellement un alliage nickel-chrome, en particulier NiCr20AlSi,
e) **que** le matériau de résistance de l'élément de résistance (6) est éventuellement un alliage fer-chrome, en particulier Fe70/Cr25/Al5,
f) **que** l'élément de résistance (6) de l'élément de résistance (6) est relié éventuellement électriquement et mécaniquement aux deux parties de raccordement (2, 3), en particulier par une liaison soudée, en particulier par un soudage par faisceau d'électrons,
g) **que** les deux parties de raccordement (2, 3) sont disposées éventuellement sur les côtés opposés de l'élément de résistance (6),
h) **que** les parties de raccordement (2, 3) et/ou l'élément de résistance (6) sont éventuellement en forme de plaque,
i) **que** les parties de raccordement (2, 3) et/ou l'élément de résistance (6) sont éventuellement planes ou courbées,
j) **que** le matériau de résistance de l'élément de résistance (6) présente de préférence une résistance électrique spécifique plus grande que le matériau conducteur des parties de raccordement (2, 3),
k) **que** le matériau de résistance de l'élément de résistance (6) présente éventuellement une résistance électrique spécifique inférieure à 1000 pQcm, 500 pQcm, 250 pQcm, 100 pQcm ou 50 pQcm,
l) que le matériau conducteur des parties de raccordement (2, 3) présente éventuellement une résistance électrique spécifique inférieure à 20 pQcm, 10 pQcm, 5 pQcm ou 2 pQcm,
m) **que** la résistance (1) présente dans son ensemble éventuellement une valeur de résistance qui est inférieure à 100 Ω, 10 Ω, 1 Ω, 100 mΩ, 10 mΩ, 1 mΩ, 100 µΩ, 10 µΩ ou 1 µΩ,
n) **que** les deux parties de raccordement (2, 3) présentent éventuellement respectivement un raccordement électrique (4, 5), afin d'introduire le courant (I) dans la résistance (1) ou de le faire sortir de la résistance (1), en particulier sous forme respectivement d'un trou (4, 5) dans les parties de raccordement (2, 3),
o) **que** la résistance (1) est éventuellement asymétrique par rapport à la direction de flux de courant principale,
p) **que** les contacts de mesure de tension (7.1, 7.2, 8.1, 8.2) dans la résistance (1) par rapport à la direction de flux de courant principale sont disposés de manière excentrée, en particulier dans le tiers ou quart latéral de la résistance (1), en particulier sur le côté des encoches.

11. Ensemble de mesure, en particulier pour la mesure de courant, avec
a) une résistance (1) selon l'une quelconque des revendications précédentes, en particulier comme résistance (1) de mesure de courant de basse impédance, et
b) un dispositif de mesure de tension (9) avec
b1) un premier canal de mesure de tension pour la mesure de la tension sur la première paire (7.1, 7.2) de contacts de mesure de tension de la résistance (1), et
b2) un deuxième canal de mesure de tension pour la mesure de la tension sur la deuxième paire (8.1, 8.2) de contacts de mesure de tension de la résistance (1).

12. Ensemble de mesure selon la revendication 11, **caractérisé par** une unité de calcul, qui
a) calcule à partir des valeurs de mesure de tension (U1, U2) mesurées dans les deux canaux de mesure selon la loi d'Ohm deux valeurs de mesure de courant (I1, 12), qui représentent respectivement le courant (I) qui circule à travers la résistance (1), dans lequel les deux valeurs de courant (I1, 12) sont redondantes, ou
b) calcule à partir des valeurs de mesure de tension (U1, U2) mesurées dans les deux canaux de mesure selon la loi d'Ohm une valeur de mesure de courant moyenne (I_{MITTEL}), qui représente le courant (I) qui circule à travers la résistance (1).
